# EUROPÄISCHE PATENTSCHRIFT

(11) **EP 3 120 456 B1**
(45) Veröffentlichungstag und Bekanntmachung des Hinweises auf die Patenterteilung: **21.04.2021**
(21) Anmeldenummer: 16706587.9
(22) Anmeldetag: 25.02.2016
(51) Int. Cl.: H03H 1/00

(54) **VORRICHTUNG ZUM ABSORBIEREN DES ELEKTRISCHEN RAUSCHENS AUF KABELN**
APPARATUS FOR ABSORBING ELECTRICAL NOISE ON CABLES
DISPOSITIF POUR ABSORBER LE BRUIT ÉLECTRIQUE DE CÂBLES

(30) Priorität: 23.03.2015 DE 102015205193
(43) Veröffentlichungstag der Anmeldung: 25.01.2017
(60) Teilanmeldung: 20181419.1
(73) Patentinhaber: Würth Elektronik eiSos GmbH & Co. KG, 74638 Waldenburg (DE)
(72) Erfinder: WEIDINGER, Robert, 5020 Salzburg (AT); TREBUCH, Simon, 5020 Salzburg (AT); SCHLEICH, Harald, 83052 Bruckmühl (DE); MÜTSCH, Steffen, 74214 Schöntal-Bieringen (DE); FIEBIG, Nils-Henning, 58791 Werdohl (DE)
(74) Vertreter: Patentanwälte Ruff, Wilhelm, Beier, Dauster & Partner mbB
(86) Internationale Anmeldenummer: PCT/EP2016/053915
(87) Internationale Veröffentlichungsnummer: WO 2016/150638

(56) Entgegenhaltungen:
- DE-A1- 19 730 108
- DE-A1-102006 027 312

## Beschreibung

Die Erfindung geht aus von einer Vorrichtung zum Absorbieren des elektrischen Rauschens auf einem Kabel. Solche Vorrichtungen sind bekannt. Zum Absorbieren des elektrischen Rauschens dienen üblicherweise Elemente aus Ferrit, die zweiteilig ausgebildet sind, damit sie nachträglich an einem Kabel angebracht werden können. Jedes Element enthält eine Rinne, die nach dem Zusammensetzen zweier Elemente einen Durchgang für das Kabel bildet. Diese Ferritelemente werden in Gehäusen untergebracht, die aus zwei Teilschalen bestehen.

Bei einer bekannten Vorrichtung dieser Art sind an den Stirnseiten beider Teilschalen Finger angeordnet, die schräg nach außen gerichtet sind und deren Enden bei geschlossenem Gehäuse an dem Kabel anliegen (US 5,003,278).

Ebenfalls bekannt ist eine Vorrichtung dieser Art (EP 1 039 632 A2), bei der an beiden Stirnseiten einer Teilschale je ein Fixiermittel angebracht ist, das einen Schlitz mit zwei parallelen Kanten zur Aufnahme des Kabels aufweist. Die Festlegung durch Klemmung geschieht dadurch, dass die Kanten mehr oder weniger stark in die Isolierung des Kabels eindrücken. Das Fixiermittel ist jeweils an der Außenseite des Gehäuses angeordnet.

Weiterhin bekannt ist eine Vorrichtung, bei der ebenfalls Fixiermittel in Form von plattenförmigen Stegen an der Außenseite der Stirnseiten einer Teilschale angeordnet sind. Die Fixiermittel weisen einen Schlitz mit parallelen Kanten zur Aufnahme des Kabels auf. Die plattenförmigen Stege, an denen die Kanten ausgebildet sind, können um eine Achse senkrecht zur Längsachse des Kabels verschwenkt werden (DE 10 2006 027 312 A1).

Eine weitere bekannte Vorrichtung zum Absorbieren des elektrischen Rauschens (DE 197 30 108 A1) weist an jeder der beiden Teilschalen des Gehäuses Fixiermittel für ein hindurchführbares Kabel auf. Die Fixiermittel sind jeweils als Bügel ausgebildet, wobei jede Teilschale einen U-förmigen Bügel aufweist. Im geschlossenen Zustand der Teilschalen sind die offenen Seiten der U-förmigen Bügel einander zugewandt und können dadurch das Kabel jeweils abschnittsweise aufnehmen. Eine Öffnung zum Durchführen und gleichzeitigem Festhalten des Kabels ist somit zwischen den beiden Bügeln gebildet, die an unterschiedlichen Teilschalen befestigt sind.

Eine weitere bekannte Vorrichtung zum Absorbieren des elektrischen Rauschens (DE 10 2010 042 743 A1) weist an einer der beiden Teilschalen des Gehäuses Fixiermittel für ein hindurchführbares Kabel auf. Die Fixiermittel sind als paarweise gegenüberliegende, plattenförmige Stege ausgebildet. Die plattenförmigen Stege können zwischen sich ein Kabel aufnehmen und klemmend fixieren.

Die bekannten Vorrichtungen sind zur nachträglichen Anbringung an Kabeln bestimmt. Sie können jeweils an Kabeln eines bestimmten Durchmesserbereichs angebracht werden, der durch den Verformungsbereich der Fixiermittel bestimmt und damit begrenzt ist.

Der Erfindung liegt die Aufgabe zu Grunde, eine Vorrichtung zum Absorbieren des Rauschens an Kabeln zu schaffen, die für einen größeren Durchmesserbereich von Kabeln verwendbar ist. Zur Lösung dieser Aufgabe schlägt die Erfindung eine Vorrichtung mit den im Anspruch 1 genannten Merkmalen vor. Weiterbildungen der Erfindung sind Gegenstand von Unteransprüchen.

Die Vorrichtung, die von der Erfindung vorgeschlagen wird, enthält also zwei Fixiermittel mit jeweils zwei Bügeln, deren einem einzulegenden oder eingelegten Kabel zugewandte und quer zum Kabel verformbare Schenkel eine Begrenzung eines Schlitzes zur klemmenden Aufnahme eines Kabels bilden. Jeweils zwei Bügel bilden zwischen sich einen Schlitz zur klemmenden Aufnahme des Kabels. Die Anpassung an unterschiedliche Kabeldurchmesser geschieht durch die Verformung der Bügel selbst, die sich quer zur Längsrichtung des Durchgangs für das Kabel verformen. Durch diese Art der Verformung kann ein größerer Bereich von Durchmessern abgedeckt werden.

Nach der Erfindung ist vorgesehen, dass die zwei Bügel U-förmig ausgebildet sind. Die Enden der Schenkel des Bügels können einstückig an der Teilschale des Gehäuses angeformt sein.

Diese Form der Bügel lässt eine Verformung in einem weiten Bereich zu, ohne dass die dabei auftretenden Kräfte zu stark variieren. Die beim Verklemmen an dem Kabel auftretenden Kräfte können sich auf eine Verformung des Schenkels und auch des die Schenkel des Bügels verbindenden Bogens verteilen. Dadurch, dass die Enden der Schenkel des Bügels an einer Teilschale angeformt sind, steht also praktisch der gesamte Bügel für eine Verformung zur Verfügung.

In Weiterbildung der Erfindung weist die dem einzulegenden oder eingelegten Kabel zugewandte Innenseite des Schenkels eine in Längsrichtung des Schenkels verlaufende Verrippung auf.

Auf diese Weise kann die Haltekraft, die auf das Kabel wirkt, erhöht werden. Wenn zwei gegenüberliegende Bügel vorhanden sind, kann vorgesehen sein, dass die einander zugewandten

Innenseiten der zwischen sich den Schlitz bildenden Schenkel eine in Längsrichtung der Schenkel verlaufende Verrippung aufweisen, die damit also quer zur Richtung des Kabels verläuft. Die Verrippung kann aus mehreren Rippen bestehen. Dadurch wird eine besonders wirksame Verstärkung der Festlegung des Gehäuses an dem Kabel erreicht, ohne dass zu starke Klemmkräfte erforderlich werden.

Es kann vorgesehen sein, dass der Querschnitt der einander zugewandten Schenkel rechteckig ist, sodass die Verrippung sich besonders einfach gestaltet.

In weiterer Ausgestaltung der Erfindung kann vorgesehen sein, dass zwei Fixiermittel an der gleichen Teilschale ausgebildet sind. Damit kann in besonders einfacher Weise das Gehäuse auch in geöffnetem Zustand an dem Kabel angebracht werden, um es anschließend schließen zu können.

Die Erfindung schlägt vor, die Bügel an der Innenseite des Gehäuses anzuordnen, also auf der Innenseite der Stirnseiten des Gehäuses, wobei zwischen der jeweiligen Innenseite und den Bügeln ein kleiner Abstand vorgesehen sein kann, so dass die Bügel sehr flexibel ausgebildet werden können. Die Fixiermittel stehen also nicht über die Stirnseite des Gehäuses vor, so dass das Gehäuse an seiner Außenseite glatt und damit auch ohne Vorsprünge ausgestaltet werden kann.

Es kann vorgesehen sein, dass das Gehäuse eine Verriegelungseinrichtung aufweist, um dieses in geschlossenem Zustand so zu verriegeln, dass es sich nicht mehr von allein öffnet. Diese Verriegelungseinrichtung kann elastische Zungen mit Vorsprüngen aufweisen, die in entsprechende Öffnungen der jeweils anderen Teilschale eingreifen.

Das Gehäuse kann in Weiterbildung der Erfindung eine Zentriereinrichtung aufweisen, die die korrekte Ausrichtung der beiden Teilschalen bei dem Schließen des Gehäuses gewährleistet.

Dabei kann es sich beispielsweise um einen einen Schlitz aufweisenden Vorsprung handeln, der mit einer Rippe an der jeweils anderen Teilschale in der Weise zusammenwirkt, dass die Rippe in den Schlitz des Vorsprungs eingreift.

Es kann vorgesehen sein, dass die beiden Teilschalen des Gehäuses aneinander angelenkt sind, beispielsweise an den in Kabelrichtung verlaufenden Kanten beider Teilschalen. Die Schließbewegung ist also eine Verschwenkung um eine Achse parallel zu dem Durchgang durch das Gehäuse. Der erwähnte, einen Schlitz aufweisende Vorsprung, der über eine Längskante der einen Teilschale vorspringt, kann an seiner Außenseite dabei so geformt sein, dass er dieser Schwenkbewegung angepasst ist, also schräg oder gebogen verläuft.

Es ist natürlich auch möglich, dass die beiden Teilschalen ineinander gesteckt werden, also nicht aneinander angelenkt sind.

In Weiterbildung der Erfindung weist jede Teilschale Mittel zum Positionieren je eines der Elemente aus einem das Rauschen verringernden bzw. absorbierenden Material relativ zur Teilschale auf.

In Weiterbildung der Erfindung sind die Mittel zum Positionieren der Elemente, insbesondere der Ferritelemente, als schräg angeordnete Zentrierungsstege ausgebildet, die beim Einsetzen der Elemente in eine jeweilige Teilschale die Elemente in ihre vorgesehene Stellung zwischen den Stirnwänden der Teilschale rücken.

Mittels der Zentrierungsstege werden also schräge Ebenen definiert, die die Elemente beim Einsetzen in die jeweilige Teilschale automatisch durch einfaches Eindrücken in die vorgesehene Stellung relativ zur Teilschale bewegen.

In Weiterbildung der Erfindung ist jede Stirnwand mit wenigstens einem Zentrierungssteg versehen, wobei sich ein Abstand zwischen den Zentrierungsstegen in Richtung auf einen Boden der jeweiligen Teilschale verringert.

Durch eine solche Anordnung der Zentrierungsstege kann durch einfaches Eindrücken der Elemente, beispielsweise Ferritelemente in Form von Halbschalen, in die Teilschale des Gehäuses eine korrekte Positionierung der Elemente erzielt werden.

In Weiterbildung der Erfindung sind die Zentrierungsstege nur an einem Ende mit der Teilschale verbunden und elastisch verformbar.

Auf diese Weise können die Zentrierungsstege elastisch verformt werden und können eine Federkraft beim Eindrücken der Elemente ausüben. Auch dann, wenn die Elemente ihre endgültige Position in der Teilschale erreicht haben, sorgen die Zentrierungsstege dann für eine Vorspannkraft auf die Elemente, so dass diese klapperfrei in der Teilschale gehalten werden können. Vorteilhafterweise sind die Zentrierungsstege mit einer jeweiligen Stirnwand der Teilschalen verbunden. In Richtung auf den Boden der jeweiligen Teilschale gesehen ist unter den Zentrierungsstegen dann eine Durchgangsöffnung im Boden der jeweiligen Teilschale angeordnet. Dies erleichtert das Herstellen der Teilschale mittels Spritzguss, insbesondere Kunststoffspritzguss, da die Zentrierungsstege dann zusammen mit der Teilschale einfach entformbar sind.

In Weiterbildung der Erfindung sind Mittel zum Stabilisieren der Bügel gegenüber axialem Zug am Kabel im geschlossenen Zustand des Gehäuses vorgesehen.

In Weiterbildung der Erfindung weisen die Mittel zum Stabilisieren der Bügel Zapfen auf, die an derjenigen Teilschale, die keine Bügel aufweist, vorgesehen sind und die im geschlossenen Zustand des Gehäuses einen Zwischenraum zwischen den Schenkeln, die das eingelegte Kabel berühren, und der benachbarten Stirnwand der Teilschale, die mit den Bügeln versehen ist, füllen.

Auf diese Weise können die Bügel gegenüber axialem Zug am Kabel in Richtung auf die jeweils benachbarte Stirnwand gesichert werden. Sind vorteilhafterweise an den beiden gegenüberliegenden Stirnwänden der Teilschale jeweils Bügel angeordnet, so sind die Bügel auf der einen Stirnseite gegen einen Zug am Kabel in einer Richtung gesichert, und die Bügel an der gegenüberliegenden Stirnwand sind gegenüber Zug am Kabel in der entgegengesetzten Richtung gesichert. Egal in welcher Richtung also am Kabel gezogen wird, wird die Zugkraft jeweils durch die Zapfen zwischen dem jeweiligen Bügel und der jeweils benachbarten Stirnwand abgeleitet, so dass die Bügel durch axialen Zug am Kabel nicht verformt oder gar beschädigt werden können. Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Einzelmerkmale der unterschiedlichen Ausführungsformen können dabei in beliebiger Weise kombiniert werden, ohne den Rahmen der Erfindung zu verlassen. In der Zeichnung zeigen:
F igur 1 eine perspektivische Ansicht eines geöffneten Gehäuses ohne die Ferritelemente;
F igur 2eine perspektivische Ansicht aus einer anderen Richtung;
F igur 3eine Ansicht in vergrößertem Maßstab.

Das in den Figuren dargestellte Gehäuse einer Vorrichtung zum Absorbieren des elektrischen Rauschens auf Kabeln enthält zwei Teilschalen 1, 2, die längs einer Längskante 3 mithilfe von Folienscharnieren 4 aneinander angelenkt sind. Dadurch können die beiden Teilschalen 1, 2 zur Bildung eines geschlossenen Gehäuses um eine parallel zur Längskante 3 verlaufende Achse verschwenkt und geschlossen werden. Jede Teilschale 1, 2 ist zur Aufnahme eines in den Zeichnungen nicht dargestellten Ferritelements bestimmt. Die beiden Teilschalen 1, 2 sind tonnenförmig ausgebildet, weisen also angenähert einen Querschnitt in Form eines halben Kreiszylinders auf.

Jede Halbschale 1, 2 weist in ihrer jeweiligen Stirnseite 5, 6 je eine halbkreisförmige Kerbe 7 auf, die im zusammengeklappten und damit geschlossenen Zustand des Gehäuses jeweils einen kreisförmigen Durchgang für ein Kabel bilden. Die dann miteinander fluchtenden Öffnungen in den beiden Stirnwänden 5, 6 bilden einen Durchgang für das Kabel.

Bei der dargestellten Ausführungsform ist das Gehäuse in Richtung des Durchgangs für das Kabel länger als in Querrichtung, was aber nicht unbedingt erforderlich ist. Wenn im Folgenden von Längsrichtung und Querrichtung gesprochen wird, soll dabei unter Längsrichtung die Richtung des Durchgangs für das Kabel verstanden werden.

Der Boden jeder Teilschale 1, 2 weist zwei in Längsrichtung versetzte Federelemente 8 auf, die dazu dienen, in geschlossenem Zustand des Gehäuses die beiden Ferritelemente so zu beaufschlagen, dass die beiden Ferritelemente aufeinander zu gedrückt werden. In Längsrichtung mittig zwischen den beiden Federelementen 8 ist ein Ausgleichsvorsprung 9 vorgesehen, der ebenfalls dazu dient, dafür zu sorgen, dass die beiden Ferritelemente korrekt aneinander anliegen.

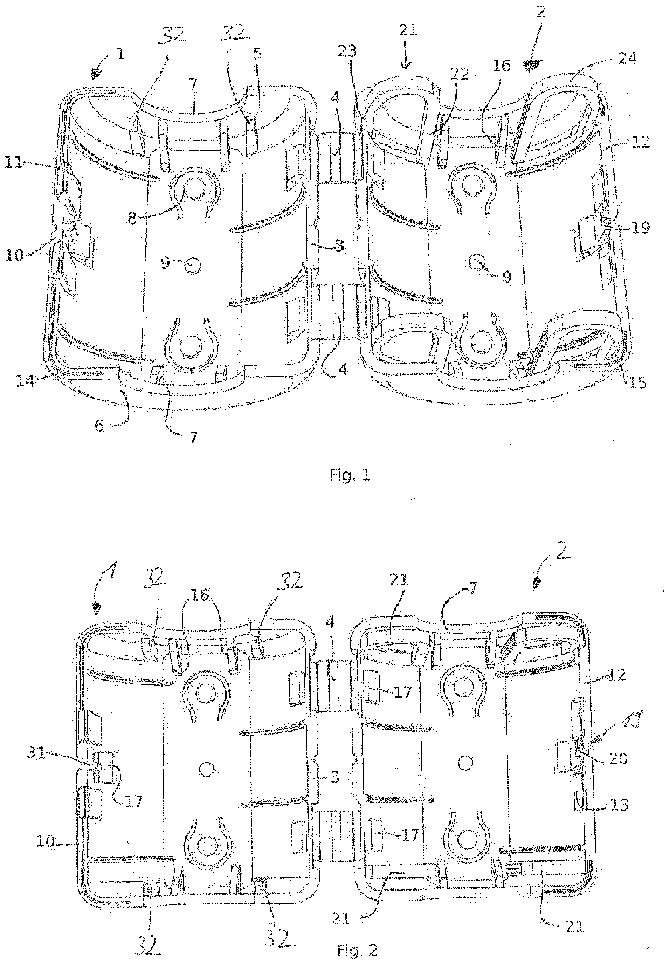

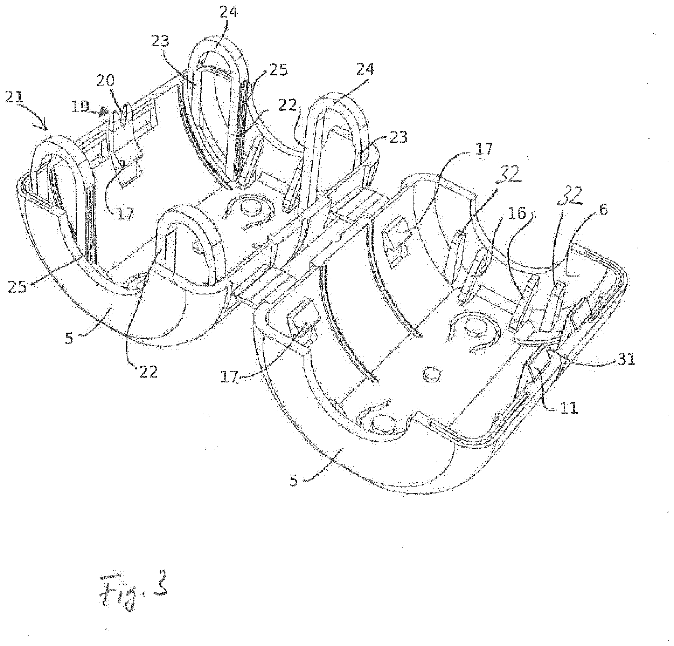

An der den Folienscharnieren 4 abgewandten äußeren Längskante 10 der in Figur 1 linken Teilschale 1 sind zwei Rastzungen 11 angeformt, die mit ihren Rastnasen in zwei an der entsprechenden äußeren Längskante 12 der jeweils anderen Teilschale 2 vorgesehene Öffnungen 13 eingreifen, wenn das Gehäuse geschlossen wird. Diese Rastzungen 11 bilden zusammen mit den Öffnungen 13 eine Verriegelungseinrichtung zur Verriegelung des Gehäuses in geschlossenem Zustand.

Im Bereich der Ecken der äußeren Längskanten 10, 12 mit den jeweiligen Stirnwänden 5, 6 sind Ausbildungen in Form von Nut 14 und Feder 15 vorgesehen, damit das Gehäuse in geschlossenem Zustand auch bei äußerer Beanspruchung in dem geschlossenen Zustand bleibt. Die Anordnung im Eckenbereich dient dazu, sowohl bei Quer- als auch bei Längsbelastungen eine Sicherung zu bewirken.

An den Innenseiten der Stirnwände 5, 6 beider Teilschalen 1, 2 sind schräg verlaufende Zentrierungsstege 16 ausgebildet, die beim Einsetzen der Ferritelemente diese in ihre richtige Stellung mittig zwischen den Stirnwänden 5, 6 rücken. Damit die Ferritelemente in der jeweiligen Halbschale festgehalten bleiben, sind an der Innenseite der Längswände der Halbschalen Vorsprünge 17 angeformt. Diese greifen in entsprechende Ausbildungen der Ferritelemente ein.

Damit beim Schließen des Gehäuses durch Verschwenken der beiden Halbschalen schnell eine korrekte Position eingenommen wird, ist eine Zentriereinrichtung vorgesehen, die einen über die Längskante 12 der einen Teilschale 2 vorspringenden Vorsprung 19 aufweist. Dieser Vorsprung 19 hat einen Schlitz 20, sodass zwei Zinken gebildet sind. Der Position des quer zu der Längskante 12 verlaufenden Schlitzes 20 entspricht eine an der Innenseite der anderen Längskante 10 der anderen Teilschale 1 angeordnete Rippe 31. Beim Schließen des Gehäuses kommt also die Rippe 31 in dem Schlitz 20 des Vorsprungs 19 zu liegen.

Die Außenseite des Vorsprungs 19 ist, der Krümmung der Innenseite der anderen Teilschale 1 entsprechend, ebenfalls etwas gekrümmt oder schräg ausgebildet.

An der Innenseite beider Stirnwände 5, 6 der in Figur 1 und 2 rechten Teilschale 2 ist, mit Abstand von diesen, je eine Fixiereinrichtung bestehend aus zwei Bügeln 21 angeordnet. Insgesamt sind an der Teilschale 2 somit vier Bügel 21 angeordnet. Die beiden Bügel 21 an der in Fig. 1 oberen Stirnwand der Teilschale 2 bilden eine Fixiereinrichtung oder ein Fixiermittel für ein Kabel und die beiden Bügel 21 an der in Fig. 1 unteren Stirnwand der Teilschale 2 bilden eine Fixiereinrichtung oder ein Fixiermittel für das Kabel. Jeder Bügel 21 ist U-förmig ausgebildet und weist einen inneren Schenkel 22, einen äußeren Schenkel 23 und einen die beiden Schenkel verbindenden Bogen 24 auf. Der äußere Schenkel 23 verläuft parallel zu dem inneren Schenkel 22, und die einander zugewandten inneren Schenkel 22 beider Bügel verlaufen ebenfalls parallel zueinander. Die inneren Schenkel 22 sind, ähnlich wie ein Balken, quer zur Längsrichtung des Gehäuses verformbar, wobei die Verformbarkeit auch durch eine Verformung des Bogens 24 unterstützt wird.

Die einander zugewandten Innenseiten der inneren Schenkel 22 weisen eine in Längsrichtung der Schenkel verlaufende Verrippung 25 auf, die die Haltekraft an dem Kabel verstärkt.

Die Enden der Schenkel 22, 23 sind mit der Teilschale 2 durch eine einstückige Anformung verbunden. Beispielsweise werden die Bügel 21 gemeinsam mit den Teilschalen 1, 2 mittels Kunststoffspritzgießen hergestellt. Die Teilschale 2 weist zwischen dem Ende der Schenkel 22, 23 jeweils eine Durchgangsöffnung auf, um das Entformen der Teilschale 2 zu erleichtern. Der Bogen 24 bildet nicht nur eine Verformungsmöglichkeit, sondern gleichzeitig eine Einführschräge beim Aufschieben der Teilschale 2 auf das Kabel. Die von dem zwischen den inneren Schenkeln 22 gebildeten Schlitz abgewandten Außenseiten des die Schenkel verbindenden Bogens 24 sind an die Innenform der jeweils anderen Teilschale 1 so angepasst, dass die Teilschale beim Schließen gerade an dem Bogen 24 vorbeigeführt werden kann und der Bogen 24 noch eine Anlage an der Innenseite der Teilschalen bewirken kann. Beim Schließen der Teilschalen 1, 2 kann die mittels der inneren Schenkel 22 auf das Kabel aufgebrachte Klemmkraft dadurch noch verstärkt werden.

Die in Fig. 1 und Fig. 2 jeweils links dargestellte Teilschale 1 des Gehäuses, also diejenige Teilschale 1, die keine Bügel 21 aufweist, ist im Bereich der jeweiligen Gehäuseöffnung auf jeder Seite mit zwei angeformten Zapfen 32 versehen. Diese Zapfen 32 ragen von der jeweiligen Stirnwand der Teilschale 1 in Richtung auf deren Innenraum vor. Im geschlossenen Zustand der beiden Teilschalen 1, 2 füllen die Zapfen 32 einen Zwischenraum zwischen den Schenkeln 22, die das eingelegte Kabel berühren, und der jeweiligen Stirnwand der Gehäuseschale 1. Im geschlossenen Zustand des Gehäuses werden dadurch die Bügel 21 gegenüber axialem Zug am Kabel stabilisiert. Durch die Vorsprünge 32 werden die in Fig. 2 an der Teilschale 2 oben liegenden Bügel 21 gegen einen axialen Zug nach oben stabilisiert, wohingegen die in Fig. 2 unten liegenden Bügel 21 durch die Vorsprünge 32 gegen einen axialen Zug nach unten stabilisiert werden. Ein axialer Zug an einem eingelegten Kabel in beiden Richtungen kann somit durch die Vorsprünge 32 an der in Fig. 2 oberen Stirnwand der Teilschale 1 bzw. durch die Vorsprünge 32 an der in Fig. 2 unteren Stirnwand der Teilschale 1 aufgefangen werden.

## Patentansprüche

1. Vorrichtung zum Absorbieren des elektrischen Rauschens auf Kabeln, mit
- einem zwei Teilschalen (1, 2) zur Aufnahme je eines Elements aus einem das Rauschen verringernden bzw. absorbieren Material enthaltenden Gehäuse, das
- in geschlossenem Zustand in beiden Stirnseiten (5, 6) je eine Öffnung für ein hindurchzuführendes Kabel aufweist, sowie mit
- zwei Fixiermitteln zum Festlegen des Gehäuses an dem Kabel, wobei
- jeweils ein Fixiermittel an jeweils einer Stirnseite (5, 6) des Gehäuses im Bereich der Öffnung angeordnet ist und
- **dadurch gekennzeichnet, dass** jedes Fixiermittel zwei Bügel (21) aufweist, jeder Bügel (21) u-förmig ausgebildet ist und einen inneren Schenkel (22) einen äußeren Schenkel (23) und einen die beiden Schenkel (22, 23) verbindenden Bogen (24) aufweist, der äußere Schenkel (23) parallel zu dem inneren Schenkel (22) verläuft, die einander zugewandten inneren Schenkel (22) ebenfalls parallel zueinander verlaufen und die inneren Schenkel (22), ähnlich wie ein Balken, quer zur Längsrichtung des Gehäuses verformbar sind, wobei die Verformbarkeit auch durch eine Verformung des Bogens (24) unterstützt wird, wobei die einander zugewandten, quer zum Kabel verformbaren Schenkel (22) der Bügel zwischen sich einen Schlitz zur klemmenden Aufnahme des Kabels bilden, wobei die einander zugewandten Schenkel (22) beider Bügel (21) parallel zueinander verlaufen.

2. Vorrichtung nach Anspruch 1, bei dem die Enden der Schenkel (22, 23) einstückig an der Teilschale (2) angeformt sind.

3. Vorrichtung nach einem der vorstehenden Ansprüche, bei der die einander zugewandten Innenseiten der Schenkel (22) eine in Längsrichtung der Schenkel (22) verlaufende Verrippung (25) aufweisen.

4. Vorrichtung nach einem der vorhergehenden Ansprüche, bei der der Querschnitt der einander zugewandten Schenkel (22) rechteckig ist.

5. Vorrichtung nach einem der vorhergehenden Ansprüche, bei der zwei Fixiermittel an der gleichen Teilschale (2) angeordnet sind.

6. Vorrichtung nach einem der vorhergehenden Ansprüche, mit einer Verriegelungseinrichtung (11, 13) zum Verriegeln des Gehäuses in geschlossenem Zustand.

7. Vorrichtung nach einem der vorhergehenden Ansprüche, mit einer Zentriereinrichtung (19) zur Gewährleistung der korrekten Ausrichtung der beiden Teilschalen (1, 2) beim Schließen des Gehäuses.

8. Vorrichtung nach einem der vorhergehenden Ansprüche, bei der die beiden Teilschalen (1, 2) des Gehäuses schwenkbar aneinander angelenkt sind.

9. Vorrichtung nach einem der vorhergehenden Ansprüche, bei der jede Teilschale (1, 2) Mittel (16) zum Positionieren je eines der Elemente aus einem das Rauschen verringernden bzw. absorbierenden Material relativ zur Teilschale (1, 2) aufweist.

10. Vorrichtung nach Anspruch 9, bei der die Mittel zum Positionieren als schräg angeordnete Zentrierungsstege (16) ausgebildet sind, die beim Einsetzen der Elemente in eine jeweilige Teilschale (1, 2) die Elemente in ihre vorgesehene Stellung zwischen den Stirnwänden (5, 6) der Teilschale (1, 2) rücken.

11. Vorrichtung nach Anspruch 10, bei der jede Stirnwand (5, 6) mit wenigstens einem Zentrierungssteg (16) versehen ist, wobei sich ein Abstand zwischen den Zentrierungsstegen in Richtung auf einen Boden der jeweiligen Teilschale (1, 2) verringert.

12. Vorrichtung nach Anspruch 10 oder 11, bei der die Zentrierungsstege (16) nur an einem Ende mit der Teilschale (1, 2) verbunden und elastisch verformbar sind.

13. Vorrichtung nach einem der vorhergehenden Ansprüche, bei der Mittel zum Stabilisieren (32) der Bügel (21) gegenüber axialem Zug am Kabel im geschlossenen Zustand des Gehäuses vorgesehen sind.

14. Vorrichtung nach Anspruch 13, bei der die Mittel zum Stabilisieren der Bügel (21) Zapfen (32) aufweisen, die an derjenigen Teilschale (1), die keine Bügel (21) aufweist, vorgesehen sind und die im geschlossenen Zustand des Gehäuses einen Zwischenraum zwischen den Schenkeln (22), die das eingelegte Kabel berühren, und der benachbarten Stirnwand (5, 6) der Teilschale (2) mit den Bügeln (21) füllen.

## Claims

1. Apparatus for absorbing electrical noise on cables, comprising
- a housing which contains two partial shells (1, 2) for receiving in each case one element which is composed of a material which decreases or absorbs noise, which housing,
- in the closed state, has in each case one opening for a cable, which is to be routed through, in the two end sides (5, 6), and also comprising
- two fixing means for securing the housing to the cable, wherein
- a respective fixing means is arranged on a respective end side (5, 6) of the housing in the region of the opening, and
- **characterized in that** each fixing means has two clips (21), each clip (21) is of U-shaped design and has an inner limb (22), an outer limb (23) and a bow (24) which connects the two limbs (22, 23), the outer limb (23) runs parallel to the inner limb (22), the inner limbs (22), which face one another, likewise run parallel to one another, and the inner limbs (22), like a bar, can be deformed transverse to the longitudinal direction of the housing, wherein the ability to deform is also assisted by deformation of the bow (24), wherein the inner limbs (22) of the clips, which face one another and can be deformed transverse to the cable, form a slot for receiving the cable in a clamping manner between them, wherein the limbs (22), which face one another, of the two clips (21) run in parallel to one another.

2. Apparatus according to claim 1, wherein the ends of the limbs (22, 23) are integrally formed on the partial shell (2).

3. Apparatus according to one of the preceding claims, wherein the inner sides, which face one another, of the limbs (22) have a ribbed portion (25) which runs in the longitudinal direction of the limbs (22).

4. Apparatus according to one of the preceding claims, wherein the cross section of the limbs (22) which face one another is rectangular.

5. Apparatus according to one of the preceding claims, wherein two fixing means are arranged on the same partial shell (2).

6. Apparatus according to one of the preceding claims, comprising a locking device (11, 13) for locking the housing in the closed state.

7. Apparatus according to one of the preceding claims, comprising a centring device (19) for ensuring the correct orientation of the two partial shells (1, 2) when closing the housing.

8. Apparatus according to one of the preceding claims, wherein the two partial shells (1, 2) of the housing are connected to one another in an articulated manner such that they can be pivoted.

9. Apparatus according to one of the preceding claims, wherein each partial shell (1, 2) has means (16) for positioning in each case one of the elements, which are composed of a material which reduces or absorbs noise, relative to the partial shell (1, 2).

10. Apparatus according to claim 9, wherein the means for positioning are designed as obliquely arranged centring webs (16) which, when the elements are inserted into a respective partial shell (1, 2), move the elements into their intended position between the end walls (5, 6) of the partial shell (1, 2).

11. Apparatus according to claim 10, wherein each end wall (5, 6) is provided with at least one centring web (16), with a distance between the centring webs decreasing in the direction of a base of the respective partial shell (1, 2).

12. Apparatus according to claim 10 or 11, wherein the centring webs (16) are connected to the partial shell (1, 2) and elastically deformable only at one end.

13. Apparatus according to one of the preceding claims, wherein means for stabilizing (32) the clips (21) against axial tension on the cable in the closed state of the housing are provided.

14. Apparatus according to claim 13, wherein the means for stabilizing the clips (21) have pins (32) which are provided on that partial shell (1) which does not have a clip (21) and which, in the closed state of the housing, fill an intermediate space between the limbs (22) which make contact with the inserted cable and the adjacent end wall (5, 6) of the partial shell (2) with the clips (21).

## Revendications

1. Dispositif permettant d'absorber le bruit électrique sur des câbles, comprenant
- un boîtier contenant deux coques partielles (1, 2) destinées à recevoir respectivement un élément d'un matériau atténuant ou absorbant le bruit, qui
- à l'état fermé, présente sur les deux faces frontales (5, 6) respectivement une ouverture pour un câble à faire passer, ainsi que comprenant
- deux moyens de fixation pour immobiliser le boîtier sur le câble, dans lequel
- respectivement un moyen de fixation est disposé sur respectivement une face frontale (5, 6) du boîtier au niveau de l'ouverture, et
- **caractérisé en ce que** chaque moyen de fixation présente deux étriers (21), chaque étrier (21) étant réalisé en forme de U et présentant une branche intérieure (22) et une branche extérieure (23) et un arc (24) reliant les deux branches (22, 23), la branche extérieure (23) s'étend en parallèle à la branche intérieure (22), les branches intérieures (22), tournées l'une vers l'autre, s'étendent également en parallèle l'une à l'autre, et les branches intérieures (22), à la manière d'une poutre, sont déformables transversalement à la direction longitudinale du boîtier, l'aptitude à la déformation étant également favorisée par une déformation de l'arc (24), dans lequel les branches (22), tournées l'une vers l'autre et déformables transversalement au câble, des étriers forment entre elles une fente pour recevoir le câble par serrage, les branches (22), tournées les unes vers les autres, des deux étriers (21) s'étendant en parallèle les unes aux autres.

2. Dispositif selon la revendication 1, dans lequel les extrémités des branches (22, 23) sont rapportées d'un seul tenant à la coque partielle (2).

3. Dispositif selon l'une quelconque des revendications précédentes, dans lequel les faces intérieures, tournées l'une vers l'autre, des branches (22) présentent un nervurage (25) s'étendant dans la direction longitudinale des branches (22).

4. Dispositif selon l'une quelconque des revendications précédentes, dans lequel la section transversale des branches (22), tournées l'une vers l'autre, est rectangulaire.

5. Dispositif selon l'une quelconque des revendications précédentes, dans lequel deux moyens de fixation sont disposés sur la même coque partielle (2).

6. Dispositif selon l'une quelconque des revendications précédentes, comprenant un dispositif de verrouillage (11, 13) permettant de verrouiller le boîtier à l'état fermé.

7. Dispositif selon l'une quelconque des revendications précédentes, comprenant un dispositif de centrage (19) permettant de garantir l'orientation correcte des deux coques partielles (1, 2) à la fermeture du boîtier.

8. Dispositif selon l'une quelconque des revendications précédentes, dans lequel les deux coques partielles (1, 2) du boîtier sont articulées l'une sur l'autre en pivotement.

9. Dispositif selon l'une quelconque des revendications précédentes, dans lequel chaque coque partielle (1, 2) présente des moyens (16) pour positionner par rapport à la coque partielle (1, 2) respectivement l'un des éléments d'un matériau atténuant ou absorbant le bruit.

10. Dispositif selon la revendication 9, dans lequel les moyens de positionnement sont réalisés sous forme d'entretoises de centrage (16), disposées en biais, qui placent les éléments dans leur position prévue entre les parois frontales (5, 6) de la coque partielle (1, 2) lorsque les éléments sont insérés dans une coque partielle (1, 2) respective.

11. Dispositif selon la revendication 10, dans lequel chaque paroi frontale (5, 6) est munie d'au moins une entretoise de centrage (16), une distance entre les entretoises de centrage diminuant en direction d'un fond de la coque partielle (1, 2) respective.

12. Dispositif selon la revendication 10 ou 11, dans lequel les entretoises de centrage (16) ne sont reliées à la coque partielle (1, 2) que par une seule extrémité, et sont déformables élastiquement.

13. Dispositif selon l'une quelconque des revendications précédentes, dans lequel des moyens sont prévus pour stabiliser (32) les étriers (21) contre une traction axiale sur le câble à l'état fermé du boîtier.

14. Dispositif selon la revendication 13, dans lequel les moyens de stabilisation des étriers (21) présentent des chevilles (32) qui sont prévues sur la coque partielle (1) qui ne présente pas d'étrier (21), et qui, à l'état fermé du boîtier, comblent un espace intermédiaire entre les branches (22) en contact avec le câble posé et la paroi frontale (5, 6) voisine de la coque partielle (2).
